Europäisches Patentamt

European Patent Office

Office européen des brevets

(19)

(11) Numéro de publication: **0 019 507**
**B1**

(12) **FASCICULE DE BREVET EUROPEEN**

(45) Date de publication du fascicule du brevet: **18.05.83**

(51) Int. Cl.³: **G 01 R 15/06, H 02 H 7/04**

(21) Numéro de dépôt: **80400554.4**

(22) Date de dépôt: **23.04.80**

(54) **Perfectionnement aux transformateurs capacitifs de tension à sortie électronique.**

(30) Priorité: **09.05.79 FR 7911690**

(43) Date de publication de la demande:
**26.11.80 Bulletin 80/24**

(45) Mention de la délivrance du brevet:
**18.05.83 Bulletin 83/20**

(84) Etats contractants désignés:
**BE CH DE GB IT LI NL SE**

(56) Documents cités:
**DE - A - 2 634 595**
**FR - A - 2 118 182**

(73) Titulaire: **ENERTEC SOCIETE ANONYME**
**12, Place des Etats Unis**
**F-92120 Montrouge (FR)**

(72) Inventeur: **Despiney, Philippe**
**38 ter Allèe de Stalingrad**
**F-94170 Le Perreux (FR)**

(74) Mandataire: **Bentz, Jean-Paul**
**GIERS SCHLUMBERGER Service BREVETS 12,**
**place des Etats-Unis**
**F-92124 Montrouge Cedex (FR)**

Courier Press, Leamington Spa, England.

Perfectionnement aux transformateurs capacitifs de tension à sortie électronique

La présente invention concerne un dispositif de prélèvement de tension sur des diviseurs capacitifs de tension et plus particulièrement sur des diviseurs dont la tension de sortie est captée par un amplificateur électronique susceptible de débiter sur une charge inductive.

Dans un diviseur capacitif, deux capacités C1 et C2 sont branchées en série entre une première et une deuxième borne entre lesquelles est appliquée une tension alternative d'alimentation dite tension primaire. La deuxième borne est en général maintenue à un potentiel de référence, la terre par exemple.

La tension aux bornes de la deuxième capacité C2, dite secondaire représente une fraction de la tension primaire, les rapports des capacités C1 et C2 définissant le rapport de division entre les tensions primaire et secondaire. Ce type de diviseur connaît une application particulièrement utile dans les transformateurs de mesure de très hautes tensions. Il permet en effet d'effectuer des mesures de tensions très élevées au primaire par prélèvement de la tension secondaire sans recourir à des transformateurs magnétiques capables de supporter ces hautes tensions avec les dispositifs d'isolement correspondants. Dans de nom breux transformateurs capacitifs de tension TCT connus de ce type, la tension secondaire prélevée aux bornes de la capacité C2 alimente le primaire d'un transformateur à induction qui réalise une réduction supplé mentaire de la tension. On a proposé de remplacer ce type de prélèvement de la tension secondaire par un prélèvement à l'aide d'un amplificateur purement électronique dont la sortie débite sur un transformateur magnétique destiné à procurer un isolement galvanique entre le TCT et des moyens d'exploitation de la mesure en aval de l'amplificateur. Cette solution, qui présente par ailleurs un certain nombre d'avantages et peut-être utilisée non seulement pour remplacer le TCT avec transformateur à induction, mais aussi sur les transformateurs de ce type pour prélever un second signal représentatif de la tension primaire, souffre cependant d'un inconvénient grave lorsque la tension alternative d'alimentation est brusquement coupée.

En effet, si cette interruption de la tension d'alimentation se produit au moment où l'amplitude de cette tension atteint une valeur élevée en valeur absolue (notamment au voisinage de la valeur de crête), les capacités du diviseur se trouvent chargées au moment du déclenchement de cette tension.

La présence de ces charges dans les capacités du diviseur et en particulier dans la capacité C2 crée certains problèmes lors du rétablissement de la tension d'alimentation du transformateur ou du diviseur capacitif.

Il ne faut pas perdre de vue en effet que si, par exemple, le diviseur capacitif fait partie d'un transformateur capacitif de tension branché entre une ligne à haute tension et le terre, le déclenchement de celle-ci à ses deux extrémités élimine toute possibilité pour les charges des capacités C1 et C2 de s'écouler. De fait, l'on constate que dans des cas de déclenchement de longue durée, les capacités, et en particulier la capacité C1, peuvent rester chargés pendant des durées extrêmement longues, seuls des courants de fuite extrêmement faibles permettant l'écoulement des charges.

En ce qui concerne la capacité C2 aux bornes de laquelle est prélevée la tension secondaire, la coupure de la tension d'alimentation peut provoquer suivant les cas deux types d'effets nuisibles dans la mesure où ils donnent naissance à des phénomènes transitoires lors du rétablissement de la tension d'alimentation. Ces phénomènes transitoires peuvent provenir, suivant les cas, soit d'un déséquilibre existant entre les états de charge de C1 et C2 au moment du rétablissement de la tension, soit de la saturation du transformateur magnétique de sortie de l'amplificateur électronique sous l'effet de la tension continue (très élevée) qui s'est trouvée présente à la sortie de l'amplificateur lorsque la tension d'alimentation a été interrompue en laissant la capacité C2 chargée. Dans ce cas en effet, la tension d'entrée de l'amplificateur électronique se maintient à une valeur maximale sur le mode continu.

La présente invention vise à remédier aux défauts énoncés ci-dessus, notamment en limitant les effets des charges piégées dans un diviseur capacitif de tension, dont l'alimentation alternative a été interrompue, sur le comportement de ce dernier lors du rétablissement de cette tension.

A cette fin, le dispositif de l'invention présente les caractéristiques énoncées dans la revendication 1.

D'autres aspects et avantages de l'invention apparaîtront à la lecture de la description suivante faite en référence aux dessins annexés sur lesquels:

la fig. 1 représente un diviseur capacitif de tension auquel est associé un amplificateur;

la fig. 2 représente un circuit mettant en oeuvre les principes de l'invention pour un diviseur capacitif de tension du type utilisé comme transformateur capacitif de tension pour la mesure des hautes tensions;

les fig. 3 et 4 sont des diagrammes de forme d'ondes illustrant le fonctionnement du dispositif de la fig. 2 dans deux types de situations d'alimentation du transformateur.

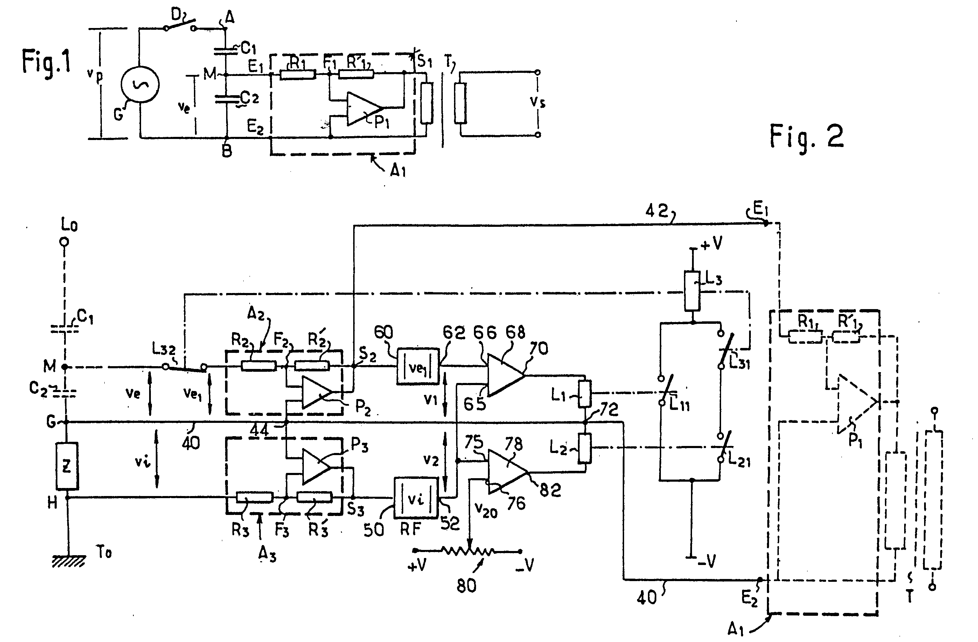

La fig. 1 représente un diviseur capacitif de tension composé de deux capacités C1 et C2 branchées en série entre deux bornes A et B. Un générateur de tension alternative par exemple de fréquence 50 Hz est susceptible de délivrer

une tension $v_p$ entre les bornes A à B lorsqu'un interrupteur D est dans la position fermée.

Chacune des capacités C1 et C2 a une armature reliée à une borne de jonction commune M. Entre les bornes M et B est branché an dispositif d'amplification électronique A1 pour prélever la tension secondaire $v_e$ (tension aux bornes du condensateur C2). Le rapport d'amplitude de la tension $v_e$ à la tension $v_p$ est déterminé par les valeurs des condensateurs C1 et C2. Il reste constant pour les valeurs instantanées de $v_p$ et $v_e$ et indépendant du régime, alternatif ou apériodique, de la tension $v_p$ si l'impédance d'entrée du dispositif électronique A1 branché aux bornes M et B est suffisamment élevée.

L'amplificateur électronique A1 comprend de façon classique une résistance d'entrée R1 dont une extrémité est raccordée à la borne M, un amplificateur opérationnel P1 monté en entrée entre la borne B et l'autre extrémité F1 de la résistance R1 et une résistance de contre réaction R'1. La sortie S1 de l'amplificateur P1 débite sur un transformateur de tension magnétique T pour fournir une tension de sortie $v_s$ à des moyens d'utilisation ainsi isolés galvaniquement du diviseur capacitif proprement dit.

En période normale d'utilisation du diviseur capacitif C1, C2, l'interrupteur D est fermé et son ouverture provoque l'interruption de la tension d'alimentation du diviseur capacitif. Il est possible que cette ouverture se produise au moment où l'amplitude de la tension alternative d'alimentation atteignait une valeur relativement élevée et notamment au voisinage de sa valeur de crête.

Dans cette situation chacun des deux condensateurs C1 et C2 se trouve chargé à une valeur élevée respectivement déterminée par sa tension aux bornes lorsque l'alimentation alternative entre les points A et B est interrompue. Lorsque l'interrupteur D reste ouvert la décharge du condensateur C1 ne peut s'effectuer que sous l'effet de courants de fuite avec une constante de temps qui peut être considérable.

En ce qui concerne le condensateur C2, il se décharge dans l'impédance d'entrée de l'amplificateur A1 en suivant une loi exponentielle dont la constante de temps est Te imposée par les valeurs de la capacité de C2 et de la résistance R1 telle que Te=R1×C2. Si l'on suppose tout d'abord Te faible, la tension aux bornes de condensateur va décroître et le transformateur T sera alimenté par une tension correspondante à la sortie de l'amplificateur A1. Si le transformateur est suffisamment dimensionné et la tension aux bornes de C2 décroissante suffisamment rapidement, le transformateur pourra supporter l'apériodique apparaissant à ses bornes sans dommage.

Il faut noter cependant que cette situation d'une constante de temps de décharge de C2 à travers A1 relativement faible correspond à une impédance d'entrée de l'amplificateur A1 également faible. Dans cette circonstance, la tension $v_e$ aux bornes de C2 se trouve déphasée en régime permanent par rapport à la tension primaire $v_p$ durant l'alimentation en régime permanent du diviseur capacitif.

Dans le cas de l'apparition d'un défaut dans la tension primaire, la tension $v_e$ risque de ne pas constituer une image fidèle de la tension primaire, un régime transitoire apparaissant entre M et B, par exemple en cas de court-circuit entre A et B. Dans ce cas, la variation du signal en sortie de l'amplificateur électronique A1 ne suit pas instantanément celle de la tension primaire. D'où l'intérêt d'une impédance d'entrée élevée pour A1 lorsque le diviseur est utilisé pour surveiller la tension primaire et notamment détecter des variations brusques de celle-ci.

En outre, toujours en se plaçant dans l'hypotèse où la constante de temps Te est faible, on constate que le condensateur C2 peut se décharger dans un temps relativement court par rapport au temps de décharge du condensateur C1. Il s'ensuit un déséquilibre des niveaux de charge des deux condensateurs et le rapport de division de tension primaire-secondaire ne sera plus respecté lors de la refermeture de l'interrupteur D, c'est à dire lors du rétablissement de la tension d'alimentation aux bornes du diviseur capacitif C1, C2. Il en résultera donc un régime transitoire sur la tension de sortie $v_s$ à la refermeture de l'interrupteur D. Ceci est également préjudiciable à un fonctionnement satisfaisant du diviseur et de son circuit électronique de sortie puisque pendant une période de temps suivant le rétablissement de la tension normale d'alimentation du diviseur, la sortie de celui-ci ne reflètera pas exactement son entrée.

L'accroissement pur et simple de la constante de temps de décharge du condensateur C2 à travers A1 fait surgir d'autres problèmes également préjudiciables au bon fonctionnement du diviseur. En effet, si l'on suppose que la constante de temps Te est élevée et, sinon égale à celle de C1, du moins longue par rapport à la durée normale d'ouverture de l'interrupteur D, il est claire que pendant tout le temps où cet interrupteur est ouvert, l'amplificateur A1 reçoit à son entrée une tension continue qui sature alors le transformateur T.

Lorsqu'on remet le diviseur capacitif C1, C2 sous tension, cette saturation du transformateur faussera le signal de sortie $v_s$ pendant tout le temps nécessaire au circuit magnétique du transformateur T pour reprendre son état normal. Un tel régime transitoire au moment du réenclenchement de l'interrupteur D est inadmissible au niveau de la sortie $v_s$ du dispositif.

A ce régime transitoire viendra bien entendu s'ajouter le régime transitoire dû à la différence des niveaux de charges de C1 et C2 au moment du réenclenchement. Comme on l'a vu précédemment, la décharge partielle de C2 produit un déséquilibre des charges des capacités C1 et C2, qui se traduit par l'apparition d'un apériodique au moment de la remise sous tension.

On a songé, tout en utilisant un amplificateur A1 à impédance d'entrée élevée, à détecter l'interruption de la tension primaire pour brancher une résistance de décharge en parallèle sur C2 afin de permettre la décharge rapide de ce dernier sans que la tension de sortie de A1 ne sature le transformateur T (DE—A 2634595). Toutefois cette solution ne permet pas d'éliminer le problème du déséquilibre des niveaux de charges de C1 et C2 au réenclenchement. Il faudrait pour cela brancher également une résistance de décharge aux bornes de C1, ce qui n'est pas réalisable en pratique dans le cas où le diviseur capacitif considéré fait partie d'un transformateur capacitif de tension pour lignes à haute tension, la tension aux bornes de C1 pouvant atteindre plusieurs centaines de milliers de volts.

Une solution envisageable pour éviter la saturation du transformateur T, sous l'effet des charges piégées dans le condensateur C2 au moment de l'interruption de la tension d'alimentation à un niveau d'amplitude élevé, consisterait à placer un filtre passe-haut à l'entrée de l'amplificateur A1 afin d'éviter l'application à ce dernier de la composante continue de la tension aux bornes de C2. Cependant un tel filtre crée un déphasage entre la tension détectée aux bornes du condensateur C2 et la sortie de l'amplificateur A1, ce qui est préjudiciable à la représentation fidèle de la tension primaire par la tension de sortie du transformateur.

En outre, un tel filtre est un lui-même la source de régimes transitoires lors de la disparition ou de la réapparition du régime permanent, ce qui n'est pas compatible avec les exigences précédemment mentionnées sur la précision et la fidélité du dispositif recherché.

Les difficultés qui viennent d'être précisées à propos de diverses solutions envisagées antérieurement, pour traiter le problème des charges piégées dans le diviseurs capacitifs lors de l'interruption de leur alimentation, peuvent être éliminées si l'on interrompt la liaison entre le condensateur C2 et le transformateur T dès que cette interruption se produit. Il convient alors de détecter cette disparition de l'alimentation du diviseur capacitif afin d'effectuer la coupure susmentionnée dans des délais suffisamment brefs pour éviter la saturation du transformateur T et minimiser la décharge du condensateur C2.

On va se référer maintenant à la fig. 2 sur laquelle est représenté un transformateur capacitif de tension branché entre un point Lo d'une ligne à haute tension et la terre. To et comportant un diviseur capacitif formé par des condensateurs C1 et C2 en série entre les les points Lo et To. Les transformateurs capacitifs de tension (TCT) sont bien connus et la présente description ne nécessite pas de description détaillée de leur structure.

La tension aux bornes de C2 est détectée par un amplificateur électronique A1 identique à l'amplificateur représenté sur la fig. 1 Sur la fig. 2, on a conservé les désignations de la fig. 1 pour les condensateurs C1 et C2, d'une part, avec leur point commun M, l'amplificateur A1 avec ses composants et le transformateur magnétique de sortie T, d'autre part. L'amplificateur A1 comporte deux entrées E1 et E2 qui sont raccordées aux bornes du condensateur C2 de la manière qui va être exposé maintenant plus en détail.

Entre le condensateur C2 et la terre est montée en série une impédance Z dont les extrémités sont désignées par G et H, la tension aux bornes du condensateur C2 étant prise entre les points M et G.

L'entrée E2 de l'amplificateur A1 est raccordée au point G par un conducteur 40. L'entrée E1 de l'amplificateur A1 est raccordée au point M par une ligne 42 à travers un amplificateur A2 et un interrupteur L32 sur la liaison de la borne M à la résistance d'entrée R2 de A2. Ainsi, la tension aux bornes M et G du condensateur C2 du diviseur capacitif, tension désignée par $v_e$ comme dans la fig. 1, est normalement appliquée, lorsque l'interrupteur L32 est fermé, aux entrées de l'amplificateur A1. Cet amplificateur, d'impédance élevée, transforme ce signal $v_e$ en un signal d'entrée du primaire du transformateur magnétique T.

L'amplificateur A1 comprend, outre la résistance d'entrée R2, un amplificateur opérationnel P2 dont une entrée est branchée à la sortie F2 de la résistance R2 et dont l'autre entrée est raccordée en un point 44 à la ligne 40, une sortie S2 pour P2 sur la ligne 42 et une résistance de contreréaction R'2 branchée entre les points F2 et S2.

L'impédance Z entre les bornes G et H est typiquement une résistance (ou un transformateur de courant) traversée en régime permanent par un courant alternative qui produit à ses bornes une tension $v_i$ représentative de ce courant.

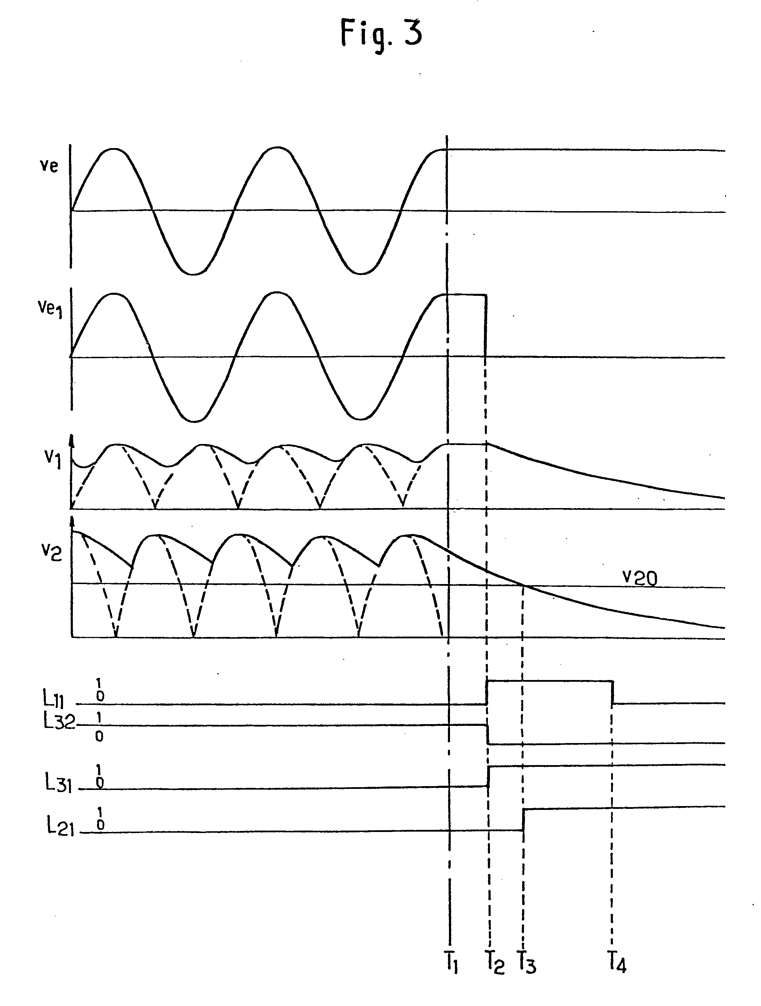

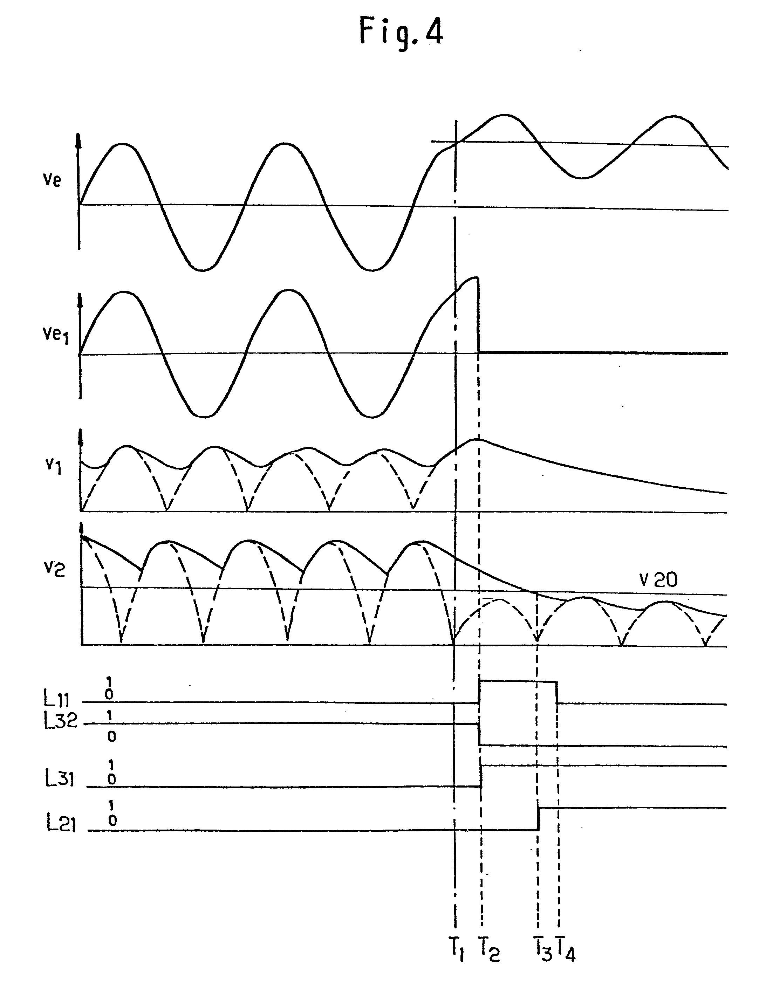

Cette tension $v_i$ est appliquée à un amplificateur A3, de construction semblable à celle de l'amplificateur A2, et comportant une résistance d'entrée R3 dont une extrémité est raccordée à H, un amplificateur opérationnel P3 dont une entrée est branchée à l'autre extrémité F3 de la résistance R3 et l'autre entrée est branchée à la borne 44 sur la ligne 40, la sortie de cet amplificateur P3 étant désignée par S3, et une résistance de contreréaction R'3 branchée entre F3 et S3. Le signal à la sortie S3 de l'amplificateur A3 est appliqué à un circuit de redressement et filtrage 50 qui en effectue d'une part le redressement à double alternance et d'autre part applique un léger filtrage au signal ainsi redressé de façon à obtenir une tension de sortie $v_2$ entre la sortie 52 du circuit redresseur filtreur RF 50 et la ligne de référence 40 dont la forme est représenté par exemple sur les diagrammes d'onde des fig. 3 et 4. Le signal $v_2$ est influencé par la valeur de crête du signal d'entrée $v_i$ représentative du

courant et tend à envelopper la partie supérieure de l'onde redressée (cette dernière est en pointillé sur les fig. 3 et 4.).

Le signal de tension présent à la sortie S2 de l'amplificateur A2 est lui aussi appliqué à un circuit de redressement et filtrage RF 50 qui effectue un redressement double alternance et un léger filtrage pour délivrer à sa sortie 62 un signal de tension $v_1$ par rapport à la tension de la ligne de référence 40 qui est représentée sur les diagrammes d'onde des fig 3 et 4. L'impédance Z choisie pour détecter le courant dans l'exemple décrit étant une résistance, on remarque que dans les deux cas de figures décrits les signaux redréssés double alternance mais avant filtrage (représentés en pointillés) $v_1$ et $v_2$ sont en quadrature de phase.

Les sorties 52 et 62 des circuits 50 et 60 sont respectivement raccordées aux entrées 65 et 66 d'un comparateur 68 dont la sortie 70 alimente la bobine d'un relais L1 dont l'autre extrémité est raccordée au point 72 à la ligne de référence 40. Ce relais commande la fermeture d'un contact L11 normalement ouvert lorsque le relais L1 n'est pas excité. Le relais de contact L11 alimente lui-même la bobine d'un relais L3 qui commande lorsque il est excité l'ouverture du . contact L32 commandant l'entrée de l'amplificateur A2 comme on l'a vu précédemment. La bobine du relais L3 est alimentée par une source d'alimentation −V, +V à laquelle elle peut être connectée, soit par la fermeture du contact L11 lorsque le relais L1 est alimenté, soit par le fermeture de deux contacts L21 et L31 en série sur une ligne parallèle au contact L11. Les contacts L31 et L21 sont commandés par des relais et sont normalement en position ouverte lorsque ces relais ne sont pas excités. Le contact L31 est commandé par le relais L3, jouant ainsi une fonction d'auto-alimentation de ce dernier lorsque L3 a été préalablement excité, par exemple lors de l'apparition d'une tension dans la relais L1 avec fermeture concomitante du contact L11.

La sortie 52 du circuit de redressement et filtrage 50 est également reliée à une entrée 75 d'un comparateur 78 dont l'autre entrée 76 est alimentée par un potentiomètre 80 qui lui fournit une tension de consigne $v_{20}$. La sortie 82 de ce comparateur alimente la bobine d'un relais L2 dont l'autre extrémité est raccordée à la borne 72 de la ligne de référence 40. Ce relais commande, lorsqu'il est excité, le fermeture du contact L21 en série avec le contact d'auto-alimentation L31 déjà mentionné.

Le principe de fonctionnement du circuit dont la structure vient d'être décrite en référence à la fig. 2 est le suivant. En régime permanent, c'est à dire lorsqu'une haute tension alternative est établie entre la ligne Lo et la terre To, la tension alternative $v_e$ prélevée aux bornes de la capacité C2 du diviseur est appliquée aux entrées E1 et E2 de l'amplificateur à haute impédance A1, en raison de la fermeture du contact L32 établissant la liaison entre la borne M et l'entrée E1 à travers l'amplificateur A2. Les paramètres des amplificateurs A2 et A3 sont déterminés à cet effet, en fonction des amplitudes nominales des tensions $v_e$ et $v_l$, pour que le signal sur l'entrée 65 du comparateur 68 soit toujours supérieur au signal apparaissant sur son entrée 66 ($v_2 > v_1$), en sorte que le niveau de sortie du comparateur 68 soit insuffisant pour exciter le relais L1, Il en résulte que le contact L11 est ouvert et que le relais L3 n'est pas alimenté. Le contact L21 reste en position ouverte, le relais L2 n'étant pas excité par le comparateur 78 tant que $v_2$ reste supérieur au seuil $v_{20}$ fixé par le potentiomètre 80.

Cette situation en régime permanent est représenté par exemple par le diagramme d'ondes de la fig. 3 jusqu'à l'instant T1, période pendant laquelle les grandeurs $v_e$, $v_{el}$ (la tension à sortie de l'interrupteur L32), $v_1$ et $v_2$ sont périodiques. Sur cette fig. 3 sont également représentées les positions des contacts L11, L32, L31, et L21, la position ouverte d'un contact étant représentée par un niveau logique zéro tandis que la position fermée (cas de L32 en régime permanent) est représentée par le niveau 1.

On suppose qu'à l'instant T1 la tension d'alimentation de la ligne est brusquement interrompue au moment où celle ci atteignait sa valeur de crête, ce qui se traduit par l'apparition d'un signal $v_e$ continu aux bornes de condensateur C2 à partir de l'instant T1. Dès cet instant le signal $v_1$ prend une valeur continue qu'il conserve jusqu'à un instant T2. Le courant traversant l'impédance Z s'annule à l'instant T1 à la suite de la rupture de l'alimentation de la ligne, et le signal $v_2$ commence à décroître progressivement en raison du filtrage exercé par le circuit 50. Au temps T2, l'amplitude du signal $v_2$ devient inférieure à l'amplitude constante atteinte par le signal $v_1$ en sorte que la relation d'amplitude des entrées 65 et 66 du comparateur s'inverse ($v_2 < v_1$) donnant naissance à un signal de commande à la sortie 70 de ce dernier qui déclenche le relais L1. L'excitation du relais L1 provoque celle du relais L3 et l'ouverture correspondant du contact L32, interrompant ainsi la connexion entre la borne M et l'amplificateur A2 (voir signal $v_{el}$ sur la fig. 3 qui retombe à 0 à l'instant T2). Dès cet instant le condensateur C2 est déconnecté de l'amplificateur A1 et se trouve dans l'impossiblilité de perdre sa charge, excepté éventuellement par des courants de fuite très faibles. Ceci présente l'avantage:

d'une part, de ne pas transmettre de tension continue à travers l'amplificateur A1 dès l'instant T2. Celui-ci peut être suffisamment proche de T1 pour éviter tout risque de saturation de transformateur pendant l'intervalle T1—T2;

d'autre part, de ne pas décharger C2 et d'avoir ainsi lors de la remise sous tension un diviseur capacitif dont les charges n'ont pas été modifiées.

La disparition de la tension d'alimentation à l'entrée de l'amplificateur A2 se traduit à partir de l'instant T2 par une décroissance du signal $v_1$ appliquée sur le comparateur 68. Pour empêcher la refermeture intempestive du contact L32, le comparateur 78 entre en jeu. Ce comparateur détecte en effet le moment où le signal $v_2$ correspondant à la tension $v_i$ (signal de courant) tombe en dessous de la valeur de consigne $v_{20}$ ce qui déclenche à l'instant T3 l'apparition d'un signal à la sortie 82 de ce comparateur et l'excitation corrélative du relais L2 avec la fermeture du contact L21. Une seconde ligne d'alimentation du relais L3 s'établit ainsi par les contacts L21 et L31 avant que la première ligne commandée par le contact L11 ne s'ouvre éventuellement à un instant T4 comme représenté sur la fig. 3. L'instant T4 correspond au moment où les deux tensions $v_1$ et $v_2$ sont tombées pratiquement à 0, le comparateur 68 cessant alors de fournir un signal de commande de L1.

A la remise sous tension, le fonctionnement du circuit est très simple. Dès la réapparition de la tension alternative d'alimentation entre les points Lo et To, le signal de courant $v_1$ résultant est amplifié par l'amplificateur A3 et résulte en une tension de sortie $v_2$ sur l'entrée 75 du comparateur 78, qui dépasse la tension de consigne $v_{20}$, en sorte que l'alimentation du relais L2 se coupe. Ceci déclenche l'ouverture du contact L21 et la déséxcitation du contact L3. Le contact L32 se referme et rétablit ainsi la liaison entre l'amplificateur de sortie A1 et la borne M du condensateur C2. Le dispositif est ainsi revenu dans l'état caractérisant le régime permanent ainsi qu'il a été expliqué plus haut.

En résumé, pour une tension d'alimentation primaire de fréquence $\omega/2\pi$ et d'amplitude Vp à laquelle correspond en régime permanent une tension secondaire de même fréquence et d'amplitude $V_e$, on peut écrire:

$$V_e = V_p \times \frac{C1}{C1+C2};\qquad (1)$$

par ailleurs l'amplitude du courant I circulant dans le diviseur et notamment à travers l'impédance Z peut s'exprimer sous la forme

$$I = C\omega Vp \text{ avec } C = \frac{C1\,C2}{C1+C2}$$

que l'on peut ramener en tenant compte de (1) à

$$I = C2\,\omega V_e \qquad (2)$$

relation vérifiée tant que la diviseur capacitif est alimenté par la tension alternative.

Si, par suite d'une interruption de cette tension d'alimentation, le tension $v_e$ aux bornes de C2 s'établit à une valeur constante, le courant à travers le diviseur tombe à zéro.

Pour détecter cette situation, on peut alors comparer constamment deux informations, l'une $v_2$ fonction directe de l'amplitude du courant, et l'autre $v_1$ fonction de la tension, l'information liée au courant $v_2$ étant normalement supérieure à l'information liée à la tension $v_1$.

Dès que l'information $v_2$ correspondant au courant tombe en dessous de la valeur de celle $v_1$ qui correspond à la tension, le produit de cette comparaison est utilisé pour déconnecter la liaison entre le condensateur C2 et la charge inductive constituée par le transformateur T à la sortie de l'amplificateur électronique et éviter ainsi de la saturer. Ainsi qu'on l'a vu, il est d'ailleurs préférable d'interrompre cette liaison avant l'amplificateur électronique plutôt qu'après puisque l'on évite ainsi pratiquement route décharge du condensateur C2 et ainsi la modification des niveaux de charge C1 et C2 jusqu'au réenclenchement.

Le choix de la valeur de la tension de consigne $v_{20}$ est dicté par les considérations suivantes: pour un transformateur capacitif de tension tel que décrit à titre d'exemple dans la fig. 2 dans un réseau à très haute tension, du type dont la tension nominale Un est de 220 kvolts ou 400 kV, la tension réelle présente sur la réseau peut varier par exemple entre 0,8 et 1,2 fois la valeur nominale. Par conséquent, le courant résultant subit des variations d'amplitude comparables par rapport à sa valeur nominale In. En outre, la fréquence des réseaux considérés est de 50Hz main elle est susceptible de glisser selon les conditions d'exploitation entre 45 et 55 Hz.

En conséquence, avec les hypothèses précédentes, le courant minimum observable lors de la remise sous tension d'une ligne préalablement déclenchée sera rencontré dans le cas où la tension réelle du réseau est égale à 80% de la tension nominale et lorsque la fréquence est de 45 Hz seulement. Il en résulte que la valeur minimale du courant susceptible de traverser l'impédance Z alors d'un réenclenchement est d'environ 70% de sa valeur nominale, ce qui fournit une valeur maximale pour le choix de $v_{20}$.

Il faut également tenir compte de la tension induite par les phases voisines sur la ligne Lo déclenchée. En effet, une ligne haute tension peut être assimilée à une capacité et, lorsqu'elle est isolée par ouverture à ses deux extrémités et chargée par exemple à la valeur de crête de la tension du réseau, elle peut recevoir en superposition sur cette tension continue une tension périodique induite par les autres phases qui restent sous tension alternative. C'est la situation illustrée par la fig. 4. L'amplitude maximale de la tension induite peut atteindre 40% de l'amplitude nominale $U_n$ et, dans ces conditions, le courant à travers Z ne tombe pas à zéro mais à une amplitude de 40% de In (fig 4). Le seuil $v_{20}$ doit donc être supérieur à l'amplitude correspondante de $v_2$. On peut donc

choisir $v_{20}$ entre 0,4 et 0,7 fois la valeur de $v_2$ correspondant à In.

En pratique, les temps d'ouverture du contact L32, après interruption de la tension d'alimentation, et de fermeture de ce contact lorsque cette tension réapparait peuvent être de l'ordre de quelques millisecondes.

On notera que les relais L1, L2 et leurs contacts associés peuvent être réalisés sous la forme de bascules à semiconducteurs. Un contact mécanique actionné par relais pourra cependant être préféré pour la réalisation du contact L32 et de sa commande L3 en raison de sa bonne tenue diélectrique aux surtensions à hautes fréquences susceptibles d'apparaître aux bornes de C2 alors des manoeuvres de déclenchement et réenclenchement de la ligne Lo.

C'est également contre ces surtensions haute fréquence que des précautions sont prises pour protéger l'impédance Z, par exemple le branchement d'un éclateur aux bornes du primaire d'un transformateur de courant captant le signal de courant.

## Revendications

1. Dispositif de prélèvement de tension sur un diviseur capacitif comportant une première et une deuxième capacités ($C_1$ et $C_2$) destinées à être branchées en série entre une borne ($L_0$) sous tension et un milieu à potentiel de référence ($T_0$), en vue d'alimenter une charge inductive en sortie (T) comportant:

des moyens (40, 42, $A_2$, $A_1$) pour effectuer une liaison à haute impédance entre deux points du diviseur de part et d'autre de la deuxième capacité ($C_2$), d'une part, et ladite charge (T), d'autre part, afin de délivrer à cette dernière un signal fonction de la tension aux bornes de la deuxième capacité;
des moyens détecteurs (Z, $A_3$, 50, 60, 68), pour détecter la disparition de la composante alternative de la tension d'alimentation ($V_p$) dudit diviseur capacitif caractérisé en ce qu'il comporte:
des moyens interrupteurs ($L_1$, $L_{11}$, $L_3$, $L_{32}$) pour interrompre ladite liaison à haute impédance en réponse à la détection par lesdits moyens de détection de la disparition de la composante alternative de la tension d'alimentation du diviseur capacitif.

2. Dispositif suivant la revendication 1, caractérisé en ce que lesdits moyens détecteurs (2, $A_3$, 50, 60, 68) sont propres à fournir un signal de commande auxdits moyens interrupteurs ($L_1$, $L_{11}$, $L_3$, $L_{32}$) lorsqu'une tension continue s'établit aux bornes d'une portion capacitive du diviseur tandis que le courant traversant ce dernier devient inférieur à une valeur de seuil.

3. Dispositif suivant la revendication 1 ou 2 caractérisé en ce que lesdits moyens détecteurs comprennent des moyens ($A_2$, 60) pour produire un signal de tension fonction de la tension aux bornes d'une portion capacitive du diviseur, des moyens (Z, $A_3$, 50) pour produire un signal de courant fonction du courant traversant le diviseur de courant fonction du courant traversant le diviseur capacitif, et des moyens (68) pour comparer lesdits signaux de courant et de tension et pour fournir un signal de commande auxdits moyens interrupteurs lorsqu'une tension alternative d'alimentation du diviseur est coupée à un instant où sa valeur n'est pas nulle.

4. Dispositif suivant la revendication 3, caractérisé en ce que les moyens pour produire un signal de courant comprennent une impédance (Z) non purement capacitive en série avec les première et seconde capacités ($C_1$ et $C_2$) et des moyens ($A_3$, 50) pour prélever la tension aux bornes de cette impédance.

5. Dispositif selon la revendication 4 dans laquelle ladite impédance (Z) est une résistance ou une transformateur de courant;

6. Dispositif selon l'une des revendications 4 ou 5, dans lequel ladite impédance (Z) est destinée à être branchée entre la deuxième capacité ($C_2$) et le milieu de référence ($T_0$).

7. Dispositif suivant l'une quelconque des revendications 1 à 6, caractérisé en ce qu'il comporte en outre des moyens (78, 80) pour détecter que le signal de courant obéit à une condition prédéterminée pour commander le maintien de l'interruption de ladite liaison à haute impédance.

8. Dispositif suivant la revendication 7, caractérisé en ce que lesdits moyens de détection (78, 80) commandent également le retour de cette liaison à sa position initiale lorsque ledit signal fonction du courant cesse d'obéir à cette condition.

## Patentansprüche

1. Vorrichtung zur Abnahme einer Spannung an einem kapazitiven Teiler, der eine erste und eine zweite Kapazität ($C_1$, $C_2$) enthält, die dazu bestimmt sind, in Reihe zwischen einen unter Spannung stehenden Anschluß ($L_0$) und ein auf Bezugspotential ($T_0$) liegendes Milieu geschaltet zu werden, um eine ausgangsseitige induktive Last (T) zu speisen, enthaltend:

Mittel (40, 42, $A_2$, $A_1$) zur Herstellung einer Verbindung hoher Impedanz zwischen zwei Teilerpunkten auf beiden Seiten der zweiten Kapazität ($C_2$) einerseits und der genannten Last (T) andererseits, um an diese ein Signal abzugeben, das von der Spannung an den Anschlüssen der zweiten Kapazität abhängt;
Detektormittel (Z, $A_3$, 50, 60, 68) zum Feststellen des Verschwindens der Wechselspannungskomponente der Versorgungsspannung ($V_p$) des kapazitiven Teilers, dadurch gekennzeichnet, daß sie enthält:
Unterbrechereinrichtungen ($L_1$, $L_{11}$, $L_3$, $L_{32}$) zum Unterbrechen der genannten Verbindung hoher Impedanz ansprechend auf die Feststellung des Verschwindens der Wechselspannungskomponente der Versorgungsspannung des kapazitven Teilers durch die Detektionsmittel.

2. Vorrichtung nach Anspruch 1, dadurch gekennzeichnet, daß die Detektionsmittel (Z, $A_3$, 50, 60, 68) geeignet sind, um ein Steuersignal an die Unterbrechereinrichtungen ($L_1$, $L_{11}$, $L_3$, $L_{32}$) abzugeben, wenn eine Gleichspannung an den Anschlüssen eines kapazitiven Teils des Teilers sich aufbaut, während der diesen durchfließende Strom geringer als ein Schwellwert wird.

3. Vorrichtung nach Anspruch 1 oder 2, dadurch gekennzeichnet, daß die Detektormittel Einrichtungen ($A_2$, 60) zur Erzeugung eines Spannungssignals umfassen, das von der Spannung an den Anschlüssen eines kapazitiven Teils des Teilers abhängt, eine Einrichtung (Z, $A_3$, 50) zur Erzeugung eines Stromsignals, das von dem durch den kapazitiven Teiler fließenden Strom abhängt, sowie eine Einrichtung (68) zum Vergleichen der Strom- und Spannungssignale und zur Abgabe eines Steuersignals an die Unterbrechereinrichtungen, wenn eine Versorgungs-Wechselspannung des Teilers zu einem Zeitpunkt abgeschaltet wird, wo ihr Wert nicht verschwindet, aufweisen.

4. Vorrichtung nach Anspruch 3, dadurch gekennzeichnet, daß die Einrichtung zur Erzeugung eines Stromsignals eine nicht rein kapazitive Impedanz (Z) in Reihe mit der ersten und der zweiten Kapazität ($C_1$ und $C_2$) und Mittel ($A_3$, 50) zum Abgreifen der Spannung an den Anschlüssen dieser Impedanz umfaßt.

5. Vorrichtung nach Anspruch 4, bei welcher die genannte Impedanz (Z) ein Widerstand oder ein Stromtransformator ist.

6. Vorrichtung nach Anspruch 4 oder 5, bei welcher die genannte Impedanz (Z) dazu bestimmt ist, zwischen die zweite Kapazität ($C_2$) und das Bezugsmilieu ($T_0$) geschaltet zu werden.

7. Vorrichtung nach einem der Ansprüche 1 bis 6, dadurch gekennzeichnet, daß sie ferner Mittel (78, 80) umfaßt, um festzustellen, daß das Stromsignal einer vorbestimmten Bedingung zum Steuern des Aufrechterhaltens der Unterbrechung der genannten Verbindung hoher Impedanz gehorcht.

8. Vorrichtung nach Anspruch 7, dadurch gekennzeichnet, daß die Detektionsmittel (78, 80) ferner die Rückführung dieser Verbindung in ihren Anfangszustand steuern, wenn das genannte stromabhängige Signal aufhört, dieser Bedingung zu gehorchen.

## Claims

1. A voltage detection means on a capacitive divider which comprises a first and a second capacitor ($C_1$ and $C_2$) intended to be connected in series between a terminal ($L_0$) under voltage and a medium at reference voltage ($T_0$), for the purposes of supplying an inductive load as output (T), comprising:

means (40, 42, $A_2$, $A_1$) for making a high-impedance connection between two points of the divider on either sides of the second capacitor ($C_2$) on the one hand, and said load (T), on the other hand, to supply to said load a signal which is a function of the voltage at the terminals of the second capacitor;

detection means (Z, $A_3$, 50, 60, 68) for detecting the disappearance of the alternating component of the supply voltage ($V_p$) of said capacitive divider, characterized in that it comprises:

switch means ($L_1$, $L_{11}$, $L_3$, $L_{32}$) for interrupting said high-impedance connection in response to detection by said detection means of the disappearance of the alternating component of the supply voltage of the capacitive divider.

2. A means according to claim 1, characterized in that said detection means (Z, $A_3$, 50, 60, 68) are designed to provide a control signal to said switch means ($L_1$, $L_{11}$, $L_3$, $L_{32}$) when a continuous voltage appears at the terminals of a capacitive portion of the divider while the current flowing through the latter falls to a lower value than a threshold value.

3. A means according to claim 1 or 2, characterized in that said detection means comprise means ($A_2$, 60) for producing a voltage signal depending on the voltage at the terminals of a capacitive portion of the divider, means (Z, $A_3$, 50) for producing a current signal depending on the current flowing through the capacitive divider, and means (68) for comparing said current and voltage signals and for providing a control signal to said switch means when an alternating supply voltage to the divider is interrupted at a time when its value is not zero.

4. A means according to claim 3, characterized in that the means for producing a current signal comprise an impedance (Z) which is not purely capacitive in series with the first and second capacitors ($C_1$ and $C_2$), and means ($A_3$, 50) for taking off the voltage at the terminals of said impedance.

5. A means according to claim 4, characterized in that said impedance (Z) is a resistor or a current transformer.

6. A means according to claim 4 or 5, characterized in that said impedance (Z) is intended to be connected between the second capacitor ($C_2$) and the reference medium ($T_0$).

7. A means according to any one of claims 1 to 6, characterized in that it comprises additionally means (78, 80) for detecting that the current signal obeys a predetermined condition for controlling the maintenance of the interruption of said high-impedance connection.

8. A means according to claim 7, characterized in that said detection means (78, 80) also control the returning of this connection to its initial state when said signal depending on the current no longer obeys this condition.

Fig.1

Fig. 2

0019507

0 019 507

Fig. 3

2

# Fig.4